# FASCICULE DE BREVET EUROPEEN

(11) **EP 2 703 295 B1**
(45) Date de publication et mention de la délivrance du brevet: **21.01.2015**
(21) Numéro de dépôt: 13181714.0
(22) Date de dépôt: 26.08.2013
(51) Int. Cl.: B64D 43/00, B64D 45/00

(54) **Ecran de visualisation transparent double-face**
Transparenter doppelseitiger Anzeigebildschirm
Double-sided transparent viewing screen

(30) Priorité: 31.08.2012 FR 1202342
(43) Date de publication de la demande: 05.03.2014
(73) Titulaire: Thales, 92200 Neuilly Sur Seine (FR)
(72) Inventeur: Dominici, Johanna, 33187 Le Haillan (FR); Ellero, Sébastien, 47600 Francescas (FR); Laluque, Laurent, 33000 Bordeaux (FR)
(74) Mandataire: Bréda, Jean-Marc

(56) Documents cités:
- EP-A1- 1 515 181
- EP-A1- 2 361 832
- EP-A1- 2 461 208
- US-A1- 2012 140 125

## Description

Le domaine de l'invention est celui des écrans de visualisation transparents. Dans certains domaines techniques, il est nécessaire de disposer de dispositifs de visualisation comportant des écrans transparents ou semi-transparents qui permettent à la fois la lecture des informations affichées et la perception du paysage situé derrière l'écran. En aéronautique, on peut utiliser de tels écrans pour donner des informations utiles concernant le pilotage ou la navigation tout en laissant à l'équipage la vision du paysage extérieur.

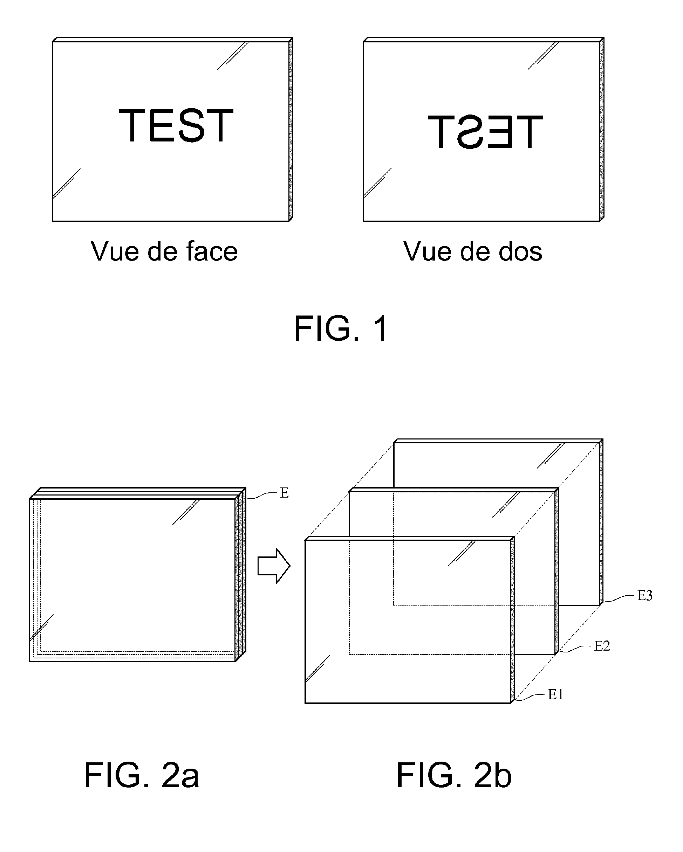

Ces écrans sont généralement des écrans à matrice active « OLED » transparentes, OLED étant l'acronyme de « Organic Light Emitting Diode ». Ces écrans émettent généralement par leurs deux faces. Il n'est pas actuellement possible de disposer de tels écrans dans des cockpits aéronautiques entre le pilote et le copilote de façon à donner simultanément des informations au pilote et au copilote sans créer de barrière opaque entre les pilotes. Ainsi, la demande EP 1 515 181 intitulée « Display » décrit un dispositif de visualisation hybride comportant deux écrans de visualisation et des « shutters » à cristaux liquides permettant d'afficher successivement et jamais simultanément les images destinées au pilote et au copilote. Comme on le voit sur la figure 1, si on dispose un écran transparent E entre le pilote et le copilote, il y a nécessairement, si l'on regarde cet écran des deux côtés, inversion de l'affichage pour un des côtés de l'écran. Les graphiques et les informations alphanumériques sont illisibles de ce côté de l'écran. Sur la figure 1, on a pris l'exemple simple du mot TEST qui est illisible à l'envers.

Pour certaines applications et notamment pour hélicoptères, de tels écrans de visualisation sont utiles dans la mesure où ils permettent de diminuer le nombre d'écrans de visualisation disposés sur la planche ce bord, face aux membres d'équipage, augmentant ainsi la perception du paysage extérieur situé devant l'équipage. En effet, les hélicoptères pouvant voler à basse altitude, il est essentiel que les membres d'équipage aient une vision la plus dégagée possible de l'extérieur.

Le dispositif de visualisation selon l'invention ne présente pas ces inconvénients. Il est composé d'un empilement de trois écrans plats, le premier étant un écran matricé émissif transparent, le second étant un écran matricé bloquant transparent, le troisième étant un écran matricé émissif transparent. Le premier écran est destiné à un premier utilisateur, le troisième écran est destiné à un second utilisateur. L'écran matricé bloquant étant convenablement agencé, ni le premier utilisateur, ni le second utilisateur ne perçoive d'affichage inversé illisible.

Plus précisément, l'invention a pour objet un dispositif de visualisation hybride, caractérisé en ce qu'il comprend au moins un empilement comportant trois écrans de visualisation de même dimensions superposés et des moyens de génération et de traitement d'images, le premier écran de visualisation étant un écran matricé émissif transparent constituant la première face de l'empilement, le second écran de visualisation étant un écran matricé à transparence contrôlée, le troisième écran de visualisation étant un écran matricé émissif transparent constituant la seconde face de l'empilement, le second écran de visualisation étant disposé entre le premier écran de visualisation et le troisième écran de visualisation de façon à pouvoir bloquer tout ou partie de l'image affichée par le premier écran de visualisation et/ou le troisième écran de visualisation, l'empilement des trois écrans étant ainsi agencé de façon à pouvoir afficher une image sur sa première face et une image sur sa seconde face.

Avantageusement, le dispositif comporte des moyens de génération d'une première image destinée à être affichée sur le premier écran de visualisation et des moyens de traitement d'image, lesdits moyens de traitement agencés de façon à :
déterminer les symboles, les textes et les caractères alphanumériques non symétriques gauche-droite présents dans ladite première image ;
opacifier au moins les zones du second écran de visualisation disposées à l'emplacement desdits symboles, desdits textes et desdits caractères alphanumériques non symétriques de la première image ;
générer au moins lesdits symboles, lesdits textes et lesdits caractères alphanumériques non symétriques gauche-droite dans une seconde image destinée à être affichée sur le troisième écran de visualisation à l'emplacement desdits symboles, desdits textes et desdits caractères alphanumériques non symétriques de la première image.

Avantageusement, les zones opacifiées du second écran de visualisation correspondent strictement à l'emplacement desdits symboles, desdits textes et desdits caractères alphanumériques non symétriques de la première image, le reste du second écran de visualisation étant transparent.

Avantageusement, le premier écran de visualisation et le troisième écran de visualisation sont des écrans matricés de type OLED et en ce que le second écran de visualisation est un écran à cristaux liquides à transmission variable ou un écran de type PDLC à polymères dispersés ou un écran à cristaux liquides à transmission et réflexion variable.

Avantageusement, le premier écran de visualisation et/ou le troisième écran de visualisation comporte une surface tactile.

L'invention concerne également un aéronef comportant un cockpit comprenant deux postes d'équipage disposés côte à côte et un pylône central disposé entre lesdits postes, caractérisé en ce que le pylône central comporte un dispositif de visualisation hybride comme défini ci-dessus, ledit dispositif de visualisation hybride étant disposé verticalement dans l'axe central du pylône de façon que la première face de l'équipement soit vue du premier poste et la seconde face de l'équipement soit vue du second poste.

L'invention sera mieux comprise et d'autres avantages apparaîtront à la lecture de la description qui va suivre donnée à titre non limitatif et grâce aux figures annexées parmi lesquelles :
La figure 1 déjà commentée représente un écran selon l'art antérieur à matrice active « OLED » transparente vu des deux côtés de l'écran ;
Les figures 2a et 2b représentent l'empilement des différents écrans d'un dispositif de visualisation selon l'invention ;
Les figures 3 et 4 représentent deux variantes de l'affichage dans un dispositif selon l'invention vu des deux côtés de l'écran.

L'objectif principal du dispositif de visualisation hybride selon l'invention est de pouvoir afficher une image vue de façon totalement lisible par ces deux faces opposées tout en conservant une certaine transparence de façon qu'un utilisateur puisse également voir à travers le dispositif de visualisation.

Il comprend, comme on le voit sur la vue assemblée de la figure 2a et la vue éclatée de la figure 2b, un empilement E comportant trois écrans de visualisation de mêmes dimensions superposés et des moyens de génération et de traitement d'images. Le premier écran de visualisation E1 est un écran matricé émissif transparent constituant la première face de l'empilement, le second écran de visualisation E2 est un écran matricé à transparence contrôlée, le troisième écran de visualisation E3 est un écran matricé émissif transparent constituant la seconde face de l'empilement, le second écran de visualisation étant disposé entre le premier écran de visualisation et le troisième écran de visualisation de façon à pouvoir bloquer tout ou partie de l'image affichée par le premier écran de visualisation et/ou le troisième écran de visualisation, l'empilement des trois écrans étant ainsi agencé de façon à pouvoir afficher une image sur sa première face et une image sur sa seconde face.

Le contrôle de la transmission lumineuse du second écran de visualisation peut être obtenu soit par absorption de la lumière, soit par réflexion. Ce deuxième mode présente l'avantage d'augmenter la luminance des écrans de visualisation.

A titre d'exemple, le premier écran de visualisation E1 et le troisième écran de visualisation E3 sont des écrans matricés de type OLED, acronyme signifiant « Organic Light Emitting Diode ». A titre d'exemple, le second écran de visualisation E2 est un écran à cristaux liquides de type LCD, acronyme signifiant « Liquid Crystal Display » dont la transmission et/ou la réflexion sont variables. On peut également utiliser pour cette fonction un écran de type PDLC, acronyme signifiant « Polymer Dispersed Liquid Crystals ».

Le premier écran de visualisation et/ou le troisième écran de visualisation peuvent comporter une surface tactile. A titre de premier exemple de réalisation, la surface tactile peut comprendre des émetteurs et des récepteurs optiques logés dans le pourtour de l'empilement et agencés de façon à déterminer la position des doigts de l'utilisateur lorsqu'ils sont sur l'écran. On peut également, à titre de second exemple de réalisation, mettre en oeuvre des technologies capacitives ou résistives.

Il existe différents modes d'utilisation du dispositif de visualisation hybride selon l'invention. Dans un premier mode d'utilisation, le second écran de visualisation E2 est totalement bloquant sur toute sa surface. Dans ce cas, la lumière issue du premier écran de visualisation E1 ne peut atteindre le troisième écran de visualisation E3. Les images affichées sur le premier écran ou le troisième écran sont donc totalement indépendantes. Elles peuvent être identiques ou différentes. Dans ce mode, les utilisateurs ne peuvent voir à travers les écrans de visualisation. Ce mode est intéressant lorsque l'affichage comporte essentiellement du texte ou lorsque la luminosité est très importante. On obtient ainsi le meilleur contraste possible des informations affichées.

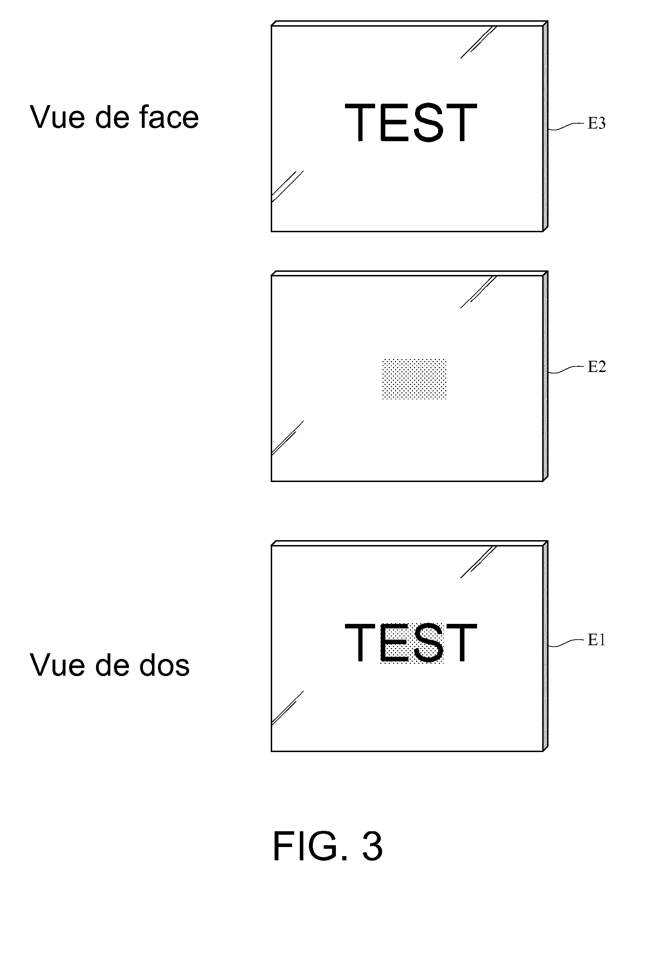

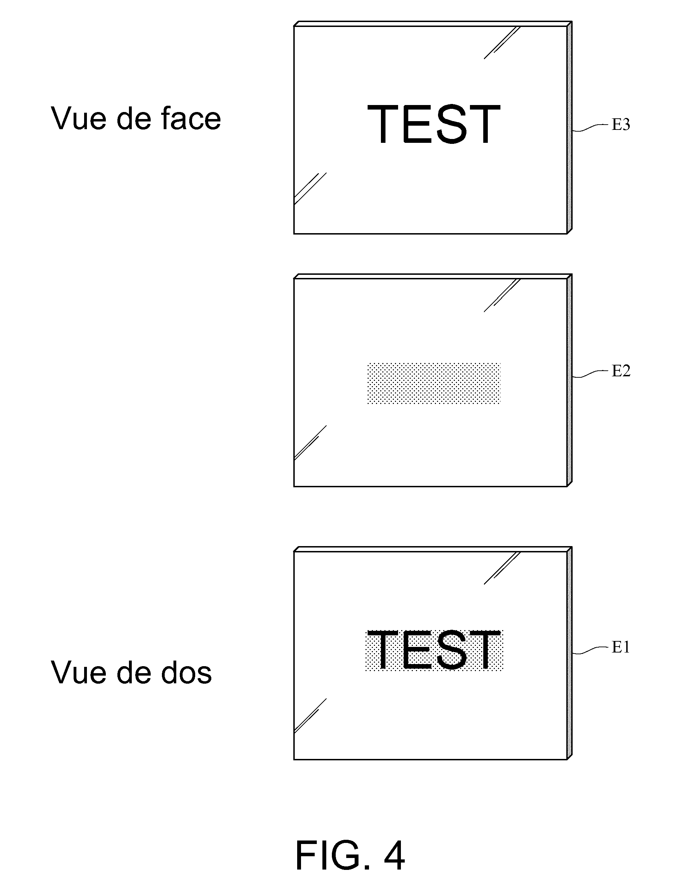

Dans un second mode d'utilisation illustrée en figures 3 et 4, on privilégie la transparence des écrans émissifs. L'objectif est d'afficher une image qui peut être lue de façon lisible par deux utilisateurs disposés de chaque côté du dispositif de visualisation et regardant chacun une face différente. La plupart des images peuvent être vues en transparence sans problèmes de lisibilité, c'est-à-dire supportent l'inversion gauche-droite. Ainsi, à titres d'exemples, une représentation cartographique ou une vue en coupe verticale d'un plan de vol supportent l'inversion gauche-droite. Seuls les textes et les caractères alphanumériques non symétriques et certains symboles deviennent illisibles par inversion gauche-droite. Le dispositif de visualisation selon l'invention permet de résoudre ce problème. Il comporte des moyens de traitement d'image agencés de façon à :
déterminer les symboles, les textes et les caractères alphanumériques non symétriques gauche-droite présents dans une première image ;
opacifier au moins les zones du second écran de visualisation disposées à l'emplacement desdits symboles, desdits textes et desdits caractères alpha-numériques non symétriques de la dite première image ;
générer au moins lesdits symboles, lesdits textes et lesdits caractères alpha-numériques non symétriques gauche-droite dans une seconde image destinée à être affichée sur le troisième écran de visualisation à l'emplacement desdits symboles, desdits textes et desdits caractères alphanumériques non symétriques de la première image.

Ce principe est illustré de façon simple sur la figure 3. On cherche à rendre lisible le mot « TEST » émis par le premier écran des deux côtés de l'empilement. Ce mot comporte deux lettres dissymétriques qui sont le E et le S et deux lettres parfaitement symétriques et disposées symétriquement qui sont les deux T extrêmes. A l'emplacement des deux lettres E et S, on opacifie le second écran de façon que ces lettres ne soient pas perçues du côté du troisième écran. Ceci correspond à la zone grisée sur la figure 3. A leur emplacement, on génère les lettres E et S dans le bon sens sur le troisième écran de visualisation. Un observateur placé du côté du troisième écran voit le mot « TEST » écrit dans le bon sens, les deux T sont issus du premier écran et le E et le S sont issus du troisième écran.

Bien entendu, il est possible d'opacifier la totalité de l'emplacement correspondant au mot de façon à obtenir un éclairement et un contraste parfaitement homogènes sur l'ensemble du mot, même si ce mot comporte des parties symétriques. Ce principe est illustré de façon simple sur la figure 4. On cherche à rendre lisible le mot « TEST » émis par le premier écran des deux côtés de l'empilement. A l'emplacement des quatre lettres T, E, S et T, on opacifie le second écran de façon que ces lettres ne soient pas perçues du côté du troisième écran. Ceci correspond à la zone grisée sur la figure 4. A leur emplacement, on génère les lettres T, E, S et T dans le bon sens sur le troisième écran de visualisation. Un observateur placé du côté du troisième écran voit le mot « TEST » écrit dans le bon sens sur fond opaque. L'avantage de cette solution est que le mot est parfaitement uniforme.

Dans le cas général, les mots ne possèdent pas de lettres disposées symétriquement et on opacifie le second écran à l'emplacement de la totalité du mot même si certaines lettres qui composent le mot sont parfaitement symétriques. Ainsi, les trois lettres du mot « OUI », bien que toutes symétriques individuellement, donnent, vues à l'envers, le mot « IUO » qui doit être totalement inversé.

L'intérêt principal de cette disposition est que le reste de l'empilement reste parfaitement transparent.

Ce type de dispositif de visualisation hybride selon l'invention est bien adapté aux hélicoptères dont le cockpit comprend deux postes d'équipage disposés côte à côte et un pylône central disposé entre lesdits postes. Le pylône central comporte alors un dispositif de visualisation hybride selon l'invention disposé verticalement dans l'axe central du pylône de façon que la première face de l'équipement soit vue du premier poste et la seconde face de l'équipement soit vue du second poste.

## Revendications

1. Dispositif de visualisation hybride, comprenant au moins un empilement comportant trois écrans de visualisation (E1, E2, E3) de même dimensions superposés et des moyens de génération et de traitement d'images, **caractérisé en ce que** le premier écran de visualisation (E1) est un écran matricé émissif transparent constituant la première face de l'empilement, le second écran de visualisation (E2) est un écran matricé à transparence contrôlée, le troisième écran de visualisation (E3) est un écran matricé émissif transparent constituant la seconde face de l'empilement, le second écran de visualisation étant disposé entre le premier écran de visualisation et le troisième écran de visualisation de façon à pouvoir bloquer tout ou partie de l'image affichée par le premier écran de visualisation et/ou le troisième écran de visualisation, l'empilement des trois écrans étant ainsi agencé de façon à pouvoir afficher une image sur sa première face et une image sur sa seconde face.

2. Dispositif de visualisation hybride selon la revendication 1, **caractérisé en ce que** le dispositif comporte des moyens de génération d'une première image destinée à être affichée sur le premier écran de visualisation et des moyens de traitement d'image, lesdits moyens de traitement agencés de façon à :
déterminer les symboles, les textes et les caractères alphanumériques non symétriques gauche-droite présents dans ladite première image ;
opacifier au moins les zones du second écran de visualisation disposées à l'emplacement desdits symboles, desdits textes et desdits caractères alphanumériques non symétriques de la première image ;
générer au moins lesdits symboles, lesdits textes et lesdits caractères alphanumériques non symétriques gauche-droite dans une seconde image destinée à être affichée sur le troisième écran de visualisation à l'emplacement desdits symboles, desdits textes ou desdits caractères alphanumériques non symétriques de la première image.

3. Dispositif de visualisation hybride selon la revendication 2, **caractérisé en ce que** les zones opacifiées du second écran de visualisation correspondent strictement à l'emplacement desdits symboles, desdits textes ou desdits caractères alphanumériques non symétriques de la première image, le reste du second écran de visualisation étant transparent.

4. Dispositif de visualisation hybride selon l'une des revendications précédentes, **caractérisé en ce que** le premier écran de visualisation et le troisième écran de visualisation sont des écrans matricés de type OLED et **en ce que** le second écran de visualisation est un écran à cristaux liquides à transmission variable ou un écran à cristaux liquides à polymères dispersés ou un écran à cristaux liquides à transmission et réflexion variable.

5. Dispositif de visualisation hybride selon l'une des revendications précédentes, **caractérisé en ce que** le premier écran de visualisation et/ou le troisième écran de visualisation comporte une surface tactile.

6. Aéronef comportant un cockpit comprenant deux postes d'équipage disposés côte à côte et un pylône central disposé entre lesdits postes, **caractérisé en ce que** le pylône central comporte un dispositif de visualisation hybride selon l'une des revendications précédentes, ledit dispositif de visualisation hybride étant disposé verticalement dans l'axe central du pylône de façon que la première face de l'équipement soit vue du premier poste et la seconde face de l'équipement soit vue du second poste.

## Patentansprüche

1. Hybridanzeigevorrichtung, die wenigstens einen Stapel mit drei aufeinander liegenden Anzeigeschirmen (E1, E2, E3) mit denselben Abmessungen sowie Mittel zum Erzeugen und Verarbeiten von Bildern umfasst, **dadurch gekennzeichnet, dass** der erste Anzeigeschirm (E1) ein transparenter emittierender Matrixschirm ist, der die erste Seite des Stapels bildet, der zweite Anzeigeschirm (E2) ein Matrixbildschirm mit geregelter Transparenz ist, der dritte Anzeigeschirm (E3) ein transparenter emittierender Matrixbildschirm ist, der die zweite Seite des Stapels bildet, wobei der zweite Anzeigeschirm zwischen dem ersten Anzeigeschirm und dem dritten Anzeigeschirm angeordnet ist, so dass das von dem ersten Anzeigeschirm und/oder dem dritten Anzeigeschirm angezeigte Bild ganz oder teilweise blockiert werden kann, wobei der Stapel von drei Schirmen auch so ausgestaltet ist, dass ein Bild auf seiner ersten Seite und ein Bild auf seiner zweiten Seite angezeigt werden können.

2. Hybridanzeigevorrichtung nach Anspruch 1, **dadurch gekennzeichnet, dass** die Vorrichtung Mittel zum Erzeugen eines ersten Bildes zur Anzeige auf dem ersten Anzeigeschirm und Bildverarbeitungsmittel umfasst, wobei die Verarbeitungsmittel so ausgelegt sind zum:
Ermitteln von in dem ersten Bild vorhandenen links-rechts nicht symmetrischen Symbolen, Texten und alphanumerischen Zeichen;
Undurchsichtigmachen wenigstens der Zonen des zweiten Anzeigeschirms, die sich am Ort der nicht symmetrischen Symbole, Texte und alphanumerischen Zeichen des ersten Bildes befinden;
Erzeugen wenigstens der links-rechts nicht symmetrischen Symbole, Texte und alphanumerischen Zeichen in einem zweiten Bild zur Anzeige auf dem dritten Anzeigeschirm am Ort der nicht symmetrischen Symbole, Texte oder alphanumerischen Zeichen des ersten Bildes.

3. Hybridanzeigevorrichtung nach Anspruch 2, **dadurch gekennzeichnet, dass** die unsichtbar gemachten Zonen des zweiten Anzeigeschirms genau dem Ort der nicht symmetrischen Symbole, Texte und alphanumerischen Zeichen des zweiten Bildes entsprechen, wobei der Rest des zweiten Anzeigeschirms transparent ist.

4. Hybridanzeigevorrichtung nach einem der vorherigen Ansprüche, **dadurch gekennzeichnet, dass** der erste Anzeigeschirm und der dritte Anzeigeschirm Matrixschirme des OLED-Typs sind, und dadurch, dass der zweite Anzeigeschirm ein Flüssigkristallanzeigeschirm mit variabler Transmission oder ein Flüssigkristallanzeigeschirm mit dispergierten Polymeren oder ein Flüssigkristallanzeigeschirm mit variabler Transmission und Reflexion ist.

5. Hybridanzeigevorrichtung nach einem der vorherigen Ansprüche, **dadurch gekennzeichnet, dass** der erste Anzeigeschirm und/oder der dritte Anzeigeschirm eine taktile Oberfläche hat/haben.

6. Luftfahrzeug mit einem Cockpit, das zwei nebeneinander angeordnete Besatzungsstationen und eine zwischen den Stationen angeordnete Mittelkonsole umfasst, **dadurch gekennzeichnet, dass** die Mittelkonsole eine Hybridanzeigevorrichtung nach einem der vorherigen Ansprüche umfasst, wobei die Hybridanzeigevorrichtung vertikal in der mittleren Achse der Konsole angeordnet ist, so dass die erste Seite des Geräts von der ersten Station und die zweite Seite des Geräts von der zweiten Station aus sichtbar ist.

## Claims

1. Device for hybrid display, comprising at least one stack which comprises three superimposed display screens (E1, E2, E3) which have the same dimensions and means for generating and processing images, **characterised in that** the first display screen (E1) is a transparent emissive matrixed screen which constitutes the first face of the stack, the second display screen (E2) is a matrixed screen with controlled transparency, the third display screen (E3) is a transparent emissive matrixed screen which constitutes the second face of the stack, the second display screen being arranged between the first display screen and the third display screen in order to be able to block all or part of the image displayed by the first display screen and/or the third display screen, the stack of three screens thus being arranged so as to be able to display an image on the first face thereof and an image on the second face thereof.

2. Hybrid display device according to claim 1, **characterised in that** the device comprises means for generating a first image which is intended to be displayed on the first display screen and image processing means, the processing means being arranged so as to:
determine the left-right non-symmetrical symbols, texts and alphanumeric characters present in the first image;
opacify at least the zones of the second display screen which are arranged at the location of the non-symmetrical symbols, texts and alphanumeric characters of the first image;
generate at least the left-right non-symmetrical symbols, texts and alphanumeric characters in a second image which is intended to be displayed on the third display screen at the location of the non-symmetrical symbols, texts or alphanumeric characters of the first image.

3. Hybrid display device according to claim 2, **characterised in that** the opacified zones of the second display screen correspond strictly to the location of the non-symmetrical symbols, texts or alphanumeric characters of the first image, the remainder of the second display screen being transparent.

4. Hybrid display device according to any one of the preceding claims, **characterised in that** the first display screen and the third display screen are matrixed screens of the OLED type and **in that** the second display screen is a liquid crystal screen with variable transmission or a liquid crystal screen with dispersed polymers or a liquid crystal screen with variable transmission and reflection.

5. Hybrid display device according to any one of the preceding claims, **characterised in that** the first display screen and/or the third display screen comprise(s) a touch surface.

6. Aircraft comprising a cockpit which comprises two crew stations which are arranged side by side and a central tower which is arranged between the stations, **characterised in that** the central tower comprises a hybrid display device according to any one of the preceding claims, the hybrid display device being arranged vertically in the central axis of the tower so that the first face of the equipment is seen from the first station and the second face of the equipment is seen from the second station.
